(19) **Europäisches Patentamt / European Patent Office / Office européen des brevets**

(11) **EP 4 670 870 A1**

(12) **EUROPEAN PATENT APPLICATION**
published in accordance with Art. 153(4) EPC

(43) Date of publication:
**31.12.2025 Bulletin 2026/01**

(21) Application number: **24760420.0**

(22) Date of filing: **21.02.2024**

(51) International Patent Classification (IPC):
$B22F\ 1/00$ (2022.01)      $B22F\ 1/05$ (2022.01)
$B22F\ 1/07$ (2022.01)      $B22F\ 1/14$ (2022.01)
$B22F\ 9/20$ (2006.01)      $B82Y\ 30/00$ (2011.01)
$C22C\ 5/00$ (2006.01)      $C22C\ 30/00$ (2006.01)

(52) Cooperative Patent Classification (CPC):
B22F 1/00; B22F 1/05; B22F 1/07; B22F 1/10;
B22F 1/107; B22F 1/14; B22F 1/142; B22F 1/145;
B22F 3/02; B22F 3/10; B22F 9/04; B22F 9/20;
B22F 10/28; B22F 10/34; B82Y 30/00;      (Cont.)

(86) International application number:
**PCT/JP2024/006397**

(87) International publication number:
**WO 2024/177122 (29.08.2024 Gazette 2024/35)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 22.02.2023  JP 2023026471
28.06.2023  JP 2023106367
28.06.2023  JP 2023106369

(71) Applicant: **Tanaka Precious Metal Technologies Co., Ltd.**
**Tokyo 1030025 (JP)**

(72) Inventors:
• **MAETO Keisuke**
  **Hiratsuka-shi, Kanagawa 2540021 (JP)**
• **KONDO Yoshie**
  **Hiratsuka-shi, Kanagawa 2540021 (JP)**
• **YAMADA Takashi**
  **Hiratsuka-shi, Kanagawa 2540021 (JP)**
• **HOSOI Takuya**
  **Hiratsuka-shi, Kanagawa 2540021 (JP)**

(74) Representative: **Scott, Stephen John**
**YUJA IP LAW**
**East Coast House**
**25 Skeldergate**
**York YO1 6DH (GB)**

(54) **MOLDED BODY, SINTERED BODY AND PRODUCTION METHODS OF THOSE**

(57) Provided are a noble metal alloy green compact and fired product having high crystallinity and excellent compositional uniformity. The green compact is formed of an alloy powder and a resin. The alloy powder is a noble metal alloy powder formed of an alloy of 5 or more noble metal elements, has an average particle diameter of 0.1 $\mu$m to 100 $\mu$m, has a crystallite size of 60 nm or more, and exhibits an X-ray diffraction spectrum in which a number of peaks observed in a diffraction angle $2\theta$ range of 38° to 44° is 1.

*FIG. 1*

```
┌─────────────────────────────────┐
│  Alloy powder preparation step  │
└─────────────────────────────────┘
                 │
                 ▼
┌─────────────────────────────────┐
│           Mixing step           │
└─────────────────────────────────┘
                 │
                 ▼
┌ ─ ─ ─ ─ ─ ─ ─ ─ ─ ─ ─ ─ ─ ─ ─ ─ ┐
           Drying step
└ ─ ─ ─ ─ ─ ─ ─ ─ ─ ─ ─ ─ ─ ─ ─ ─ ┘
                 │
                 ▼
┌─────────────────────────────────┐
│         Compacting step         │
└─────────────────────────────────┘
```

EP 4 670 870 A1

(52) Cooperative Patent Classification (CPC): (Cont.)
**B82Y 35/00; B82Y 40/00; C22C 5/00; C22C 30/00;
C23C 14/34**

**Description**

TECHNICAL FIELD

The present disclosure relates to a green compact, a fired product, and methods of producing these products.

BACKGROUND

Powder metallurgy is a technique whereby a metal powder serving as a raw material is mixed with a binder as necessary and is subsequently subjected to compacting and firing to obtain a metal product (fired product). Powder metallurgy techniques enable the production of products having various compacts through the use of molds having compacts in accordance with these products. Moreover, in powder metallurgy, it is also possible to mix a plurality of metal powders in order to produce a product that is formed of an alloy of these metals. The alloy composition of the resultant product and various physical properties that are determined by the alloy composition can be altered by adjusting the blending proportion of each metal powder during mixing. Such advantages have meant that powder metallurgy is adopted in production of various products.

Although powder metallurgy is mainly used in the production of products formed of Fe, Cu, Ni, Cr, W, Mo, Ti, and so forth, the use of powder metallurgy has also been proposed for production of noble metal alloy products.

For example, Patent Literature (PTL) 1 proposes mixing a plurality of raw material powders formed of different components and subsequently performing compacting and sintering to produce a noble metal alloy sintered product formed of elements such as Au, Ag, and Cu.

Examples of noble metal elements include gold (Au), silver (Ag), platinum (Pt), palladium (Pd), rhodium (Rh), iridium (Ir), ruthenium (Ru), and osmium (Os). Although these elements belong to a single group referred to as the noble metal elements, these elements differ from one another in terms of actual physical and chemical characteristics. Moreover, noble metal alloys formed of these noble metal elements are known to have significantly different properties depending on the composition thereof. For this reason, there is anticipation around the use of powder metallurgy techniques to produce sintered products formed of various noble metal alloys.

Furthermore, in recent years, there has been ongoing research related to high-entropy alloys formed of noble metals. Although the meaning of high-entropy alloy varies depending on the definition that is adopted, the term "high-entropy alloy" according to a narrow definition refers to an alloy that contains roughly equiatomic quantities of 5 or more elements and in which a single phase solid solution is formed. High-entropy alloys are attracting attention due to having significantly different properties to typical alloys. High-entropy alloys in which base metal elements such as Cr, Mn, Fe, Co, and Ni are used are more common, but there are also instances in which high-entropy alloys are synthesized from only noble metal elements.

For example, in Non-Patent Literature (NPL) 1, a powder of a high-entropy alloy that is formed of 8 noble metal elements is produced by a wet reduction method (also referred to as a liquid-phase reduction method or a chemical reduction method). Moreover, it is clear from NPL 1 that this powder displays exceptional hydrogen evolution reaction catalytic activity.

As set forth above, multicomponent noble metal alloys that are formed of multiple noble metal elements are attracting interest.

CITATION LIST

Patent Literature

PTL 1: JP H06-057303 A

Non-Patent Literature

NPL 1: Journal of the American Chemical Society, February 2022, Vol. 144, No. 8, p.3365-3369

SUMMARY

(Technical Problem)

However, studies conducted by the inventors have revealed that conventional powder metallurgy techniques are not suitable for producing products that are formed of multicomponent noble metal alloys such as described above.

For example, in a situation in which a plurality of powders formed of different components are mixed and then used, there are instances in which the compact of a fired product cannot be maintained due to embrittlement and crumbling that occur upon resin removal through firing. Although the reason for this is not completely clear, the large difference in characteristics such as melting point between the noble metal elements is thought to be a factor.

The inventors also found that even when the strength of a fired product is not a problem, microscopic non-uniformity of the distribution of constituent elements in the fired product may arise (i.e., variation of alloy composition may arise). Since variation of alloy composition means that there is also variation of characteristics, there is demand for a noble metal alloy fired product having excellent compositional uniformity in order that the original characteristics of the noble metal alloy are displayed.

In particular, it is considered to be desirable to reduce compositional non-uniformity to as great an extent as possible when producing a high-entropy alloy such as previously described. In other words, the presence of compositional non-uniformity means that the condition of inclusion of an equiatomic quantity of each element is not satisfied in the portion where there is non-uniformity, and thus it may not be possible to obtain the original characteristics of the high-entropy alloy. Moreover, there are instances in which a single phase solid solution cannot be formed when there is high compositional non-uniformity.

Furthermore, physical properties of noble metals are known to also be largely dependent on crystallinity. For this reason, there is demand for a noble metal alloy fired product such as described above to have high crystallinity.

An object of the present disclosure is to solve the problems set forth above and provide a green compact and fired product of a noble metal alloy having high crystallinity and excellent compositional uniformity.

(Solution to Problem)

As a result of studies conducted to achieve the object set forth above, the inventors discovered that by using a noble metal alloy powder having a specific average particle diameter, crystallite size, and number of peaks in an X-ray diffraction spectrum, instead of using a plurality of powders formed of different components, it is possible to solve the problems set forth above. The present disclosure was completed based on the finding described above, and the primary features thereof are as follows.

1. A green compact comprising an alloy powder and a resin, wherein the alloy powder:

is a noble metal alloy powder formed of an alloy of 5 or more noble metal elements;
has an average particle diameter of 0.1 $\mu$m to 100 $\mu$m;
has a crystallite size of 60 nm or more; and
exhibits an X-ray diffraction spectrum in which a number of peaks observed in a diffraction angle $2\theta$ range of 38° to 44° is 1.

2. The green compact according to the foregoing 1, wherein the noble metal alloy powder has a coefficient of variation CV of content measured by energy dispersive X-ray spectroscopy of 0.2 or less for each of the noble metal elements.

3. A fired product of a noble metal alloy, wherein

the noble metal alloy is a noble metal alloy formed of 5 or more noble metal elements, and
the fired product:

has a crystallite size of 60 nm or more; and
exhibits an X-ray diffraction spectrum in which a number of peaks observed in a diffraction angle $2\theta$ range of 38° to 44° is 1.

4. The fired product according to the foregoing 3, wherein a coefficient of variation CV of content measured by energy dispersive X-ray spectroscopy is 0.2 or less for each of the noble metal elements.

5. A method of producing a green compact formed of an alloy powder and a resin, comprising:

an alloy powder preparation step of preparing the alloy powder as a raw material;
a mixing step of mixing the resin with the alloy powder; and
a compacting step of applying pressure to the alloy powder and the resin that have been mixed in the mixing step to obtain a green compact, wherein
the alloy powder:

is a noble metal alloy powder formed of an alloy of 5 or more noble metal elements;
has an average particle diameter of 0.1 $\mu$m to 100 $\mu$m;

has a crystallite size of 60 nm or more; and
exhibits an X-ray diffraction spectrum in which a number of peaks observed in a diffraction angle 2θ range of 38° to 44° is 1.

6. The method of producing a green compact according to the foregoing 5, wherein

a solvent is mixed with the alloy powder in addition to the resin in the mixing step, and
the method further comprises a drying step of evaporating the solvent after the mixing step and before the compacting step.

7. A method of producing a fired product of a noble metal alloy, comprising:

an alloy powder preparation step of preparing an alloy powder as a raw material;
a mixing step of mixing a resin with the alloy powder;
a compacting step of applying pressure to the alloy powder and the resin that have been mixed in the mixing step to obtain a green compact; and
a firing step of firing the green compact to obtain a fired product, wherein
the alloy powder:

is a noble metal alloy powder formed of an alloy of 5 or more noble metal elements;
has an average particle diameter of 0.1 μm to 100 μm;
has a crystallite size of 60 nm or more; and
exhibits an X-ray diffraction spectrum in which a number of peaks observed in a diffraction angle 2θ range of 38° to 44° is 1.

8. The method of producing a fired product according to the foregoing 7, wherein

a solvent is mixed with the alloy powder in addition to the resin in the mixing step, and
the method further comprises a drying step of evaporating the solvent after the mixing step and before the compacting step.

(Advantageous Effect)

According to the present disclosure, it is possible to provide a green compact and fired product of a noble metal alloy having high crystallinity and excellent compositional uniformity.

BRIEF DESCRIPTION OF THE DRAWINGS

In the accompanying drawings:

FIG. 1 is a flow chart illustrating a method of producing a noble metal alloy green compact in one embodiment of the present disclosure;
FIG. 2 is a flow chart illustrating a method of producing a noble metal alloy fired product in one embodiment of the present disclosure;
FIG. 3 is a flow chart illustrating one example of a method of producing a noble metal alloy powder as a raw material;
FIG. 4 is a flow chart illustrating another example of a method of producing a noble metal alloy powder as a raw material; and
FIG. 5 is a flow chart illustrating another example of a method of producing a noble metal alloy powder as a raw material.

DETAILED DESCRIPTION

The following provides a specific description of embodiments of the present disclosure. It should be noted that the present disclosure is not limited to the embodiments described below.

[Green compact]

A green compact in one embodiment of the present disclosure is a green compact that is formed of an alloy powder and a resin. The alloy powder is a noble metal alloy powder formed of an alloy of 5 or more noble metal elements and satisfies the following conditions.

- Average particle diameter of 0.1 $\mu$m to 100 $\mu$m
- Crystallite size of 60 nm or more
- X-ray diffraction spectrum in which the number of peaks observed in a diffraction angle $2\theta$ range of 38° to 44° is 1

• Noble metal elements

Any noble metal elements can be used without any specific limitations as the constituent noble metals of the noble metal alloy. In other words, the noble metal alloy is an alloy formed of 5 or more elements selected from the group consisting of Au, Ag, Pt, Pd, Rh, Ir, Ru, and Os.

Note that among the noble metal elements mentioned above, Os has a property of readily volatilizing upon heating in a production process. Therefore, from a viewpoint of ease of production, it is preferable that the noble metal alloy is an alloy formed of 5 or more elements selected from the group consisting of Au, Ag, Pt, Pd, Rh, Ir, and Ru.

The number of constituent noble metal elements of the alloy should be 5 or more, but no specific limitations are placed on the upper limit for the number of constituent noble metal elements. In other words, all 8 of the noble metal elements may be included. The number of noble metal elements may be 6 or may be 7.

The proportion (content) of each noble metal element contained in the noble metal alloy powder is not specifically limited and can be set as any value. For example, when a noble metal alloy powder that is formed of a high-entropy alloy such as previously described is to be produced, the proportions of noble metal elements contained in the noble metal alloy powder should be roughly equal values. Specifically, $\Delta C$, which is defined as the difference (Cmax - Cmin) between a largest content (Cmax) and a smallest content (Cmin) among contents (atom%) of all noble metal elements contained in the noble metal alloy powder, is preferably 10.0 atom% or less, more preferably 5.0 atom% or less, even more preferably 3.0 atom% or less, and most preferably 2.0 atom% or less. On the other hand, the lower $\Delta C$ is the better, and the lower limit may be 0 atom%.

• Average particle diameter: 0.1 $\mu$m to 100 $\mu$m

When the average particle diameter of the alloy powder is less than 0.1 $\mu$m, the apparent density noticeably decreases. A low powder apparent density results in extremely large contraction (reduction of volume) during compacting. Therefore, the average particle diameter is set as 0.1 $\mu$m or more. On the other hand, when the average particle diameter is larger than 100 $\mu$m, the green compact becomes brittle. Therefore, the average particle diameter is set as 100 $\mu$m or less, preferably 80 $\mu$m or less, more preferably 50 $\mu$m or less, even more preferably 20 $\mu$m or less, and most preferably 10 $\mu$m or less.

Note that the average particle diameter of the noble metal alloy powder referred to here is defined as indicating the 50% particle diameter D50 in a cumulative particle size distribution by volume (i.e., the median diameter). The average particle diameter can be measured using a laser diffraction particle size analyzer.

• Crystallite size: 60 nm or more

The noble metal alloy powder contained in the green compact has high crystallinity and, more specifically, has a crystallite size of 60 nm or more, and preferably 80 nm or more. On the other hand, the upper limit for the crystallite size is not specifically limited but may typically be 140 nm or less, or may be 120 nm or less.

The crystallite size can be determined from the full width at half maximum of a diffraction peak obtained through X-ray diffraction (XRD) measurement.

• Number of peaks in XRD spectrum: 1

In a situation in which noble metal elements contained in a noble metal alloy powder are not sufficiently alloyed, a plurality of peaks originating from the various elements are observed in a diffraction angle $2\theta$ range of 38° to 44° in an X-ray diffraction spectrum. Therefore, in the present disclosure, the number of peaks observed in the range set forth above is stipulated as 1. When the number of peaks in the XRD spectrum is 1, uniform alloying can be said to have been achieved. Note that the reason that the diffraction angle $2\theta$ range in which the number of peaks is counted is set as 38° to 44° is that peaks for noble metal elements (Au, Ag, Pt, Pd, Rh, Ir, Ru, and Os) are observed in this range.

• Coefficient of variation CV of content measured by EDX

The coefficient of variation CV of content measured by energy dispersive X-ray spectroscopy (EDX) is preferably 0.2 or less, and more preferably 0.15 or less for each of the constituent noble metal elements of the noble metal alloy powder. Note that when the coefficient of variation CV is said to be 0.2 or less, this means that the coefficient of variation CV of content of each of the constituent noble metal elements of the noble metal alloy powder is 0.2 or less. Through the subsequently described production method, it is possible to obtain a powder of a noble metal alloy that is extremely uniform such that the coefficient of variation CV is 0.2 or less. On the other hand, no specific limitations are placed on the lower limit for the coefficient of variation CV because the lower the coefficient of variation CV is the better. Typically, the coefficient of variation CV may be 0.05 or more, or may be 0.08 or more.

When the coefficient of variation CV of content measured by EDX satisfies the condition set forth above, even more uniform alloying can be said to have been achieved.

The green compact can be used in any application without any specific limitations. For example, the green compact can be used in that form as a final product in applications where particularly high strength is not required. Alternatively, the green compact may be used for producing a fired product described below.

[Fired product]

A fired product in one embodiment of the present disclosure is a fired product of a noble metal alloy in which the noble metal alloy satisfies the following conditions.

- Crystallite size of 60 nm or more
- X-ray diffraction spectrum in which the number of peaks observed in a diffraction angle $2\theta$ range of 38° to 44° is 1

• Noble metal elements

Any noble metal elements can be used without any specific limitations as the constituent noble metals of the noble metal alloy. In other words, the noble metal alloy is an alloy formed of 5 or more elements selected from the group consisting of Au, Ag, Pt, Pd, Rh, Ir, Ru, and Os.

Note that among the noble metal elements mentioned above, Os has a property of readily volatilizing upon heating in a production process. Therefore, from a viewpoint of ease of production, it is preferable that the noble metal alloy is an alloy formed of 5 or more elements selected from the group consisting of Au, Ag, Pt, Pd, Rh, Ir, and Ru.

The number of constituent noble metal elements of the alloy should be 5 or more, but no specific limitations are placed on the upper limit for the number of constituent noble metal elements. In other words, all 8 of the noble metal elements may be included. The number of noble metal elements may be 6 or may be 7.

The proportion (content) of each noble metal element contained in the noble metal alloy fired product according to the present disclosure is not specifically limited and can be set as any value. For example, when a noble metal alloy fired product formed of a high-entropy alloy such as previously described is to be produced, the proportions of noble metal elements contained in the noble metal alloy powder should be roughly equal values. Specifically, $\Delta C$, which is defined as the difference (Cmax - Cmin) between a largest content (Cmax) and a smallest content (Cmin) among contents (atom%) of all noble metal elements contained in the noble metal alloy fired product, is preferably 10.0 atom% or less, more preferably 5.0 atom% or less, even more preferably 3.0 atom% or less, and most preferably 2.0 atom% or less. On the other hand, the lower AC is the better, and the lower limit may be 0 atom%.

• Crystallite size: 60 nm or more

The fired product according to the present disclosure has high crystallinity and, more specifically, has a crystallite size of 60 nm or more, and preferably 80 nm or more. On the other hand, the upper limit for the crystallite size is not specifically limited but may typically be 140 nm or less, or may be 120 nm or less.

The crystallite size can be determined from the full width at half maximum of a diffraction peak obtained through X-ray diffraction (XRD) measurement.

• Number of peaks in XRD spectrum: 1

In a situation in which noble metal elements contained in a fired product are not sufficiently alloyed, a plurality of peaks originating from the various elements are observed in a diffraction angle $2\theta$ range of 38° to 44° in an X-ray diffraction spectrum. In the present disclosure, the number of peaks observed in the range set forth above is stipulated as 1. When the number of peaks in the XRD spectrum is 1, uniform alloying can be said to have been achieved. Note that the reason that the diffraction angle 2θ range in which the number of peaks is counted is set as 38° to 44° is that peaks for noble metal elements (Au, Ag, Pt, Pd, Rh, Ir, Ru, and Os) are observed in this range.

• Coefficient of variation CV of content measured by EDX

In the present disclosure, the coefficient of variation CV of content measured by energy dispersive X-ray spectroscopy (EDX) is preferably 0.2 or less, and more preferably 0.15 or less for each of the constituent metal elements of the noble metal alloy. Note that when the coefficient of variation CV is said to be 0.2 or less, this means that the coefficient of variation CV of content of each of the constituent noble metal elements of the noble metal alloy is 0.2 or less. According to the present disclosure, it is possible to obtain a fired product of a noble metal alloy that is extremely uniform such that the coefficient of variation CV is 0.2 or less. On the other hand, no specific limitations are placed on the lower limit for the coefficient of variation CV because the lower the coefficient of variation CV is the better. Typically, the coefficient of variation CV may be 0.05 or more, or may be 0.08 or more.

When the coefficient of variation CV of content measured by EDX satisfies the condition set forth above, even more uniform alloying can be said to have been achieved.

The fired product can be used in any application without any specific limitations. For example, characteristics of the noble metal alloy can be exploited through use in applications such as hydrogen storage materials, molecular sieves, catalysts, electrodes, and contacts. The fired product according to the present disclosure provides a uniform reaction field as a result of being uniformly alloyed as described above. Consequently, a reaction can be caused to progress uniformly throughout the entire fired product, and the reaction efficiency per unit amount of used noble metal can be increased. Moreover, high crystallinity means that the noble metal elements are present in a stable state. Accordingly, degradation during use is suppressed, and excellent durability is obtained.

[Production methods]

Next, methods of producing a green compact and a fired product in one embodiment of the present disclosure are described.

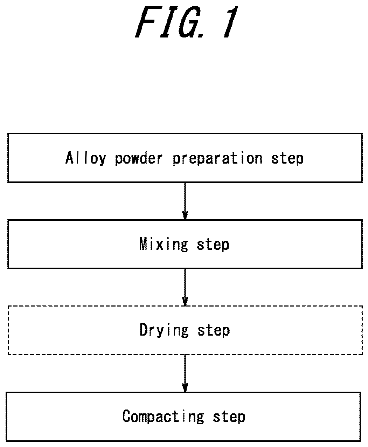

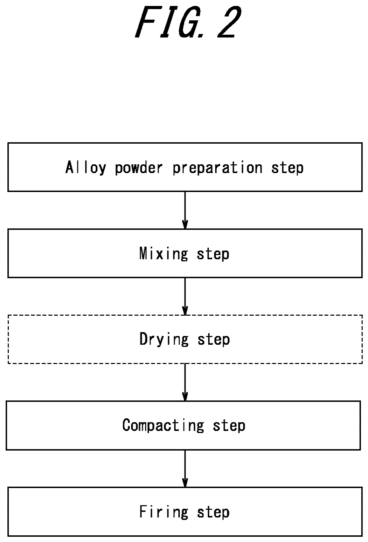

The green compact and fired product according to the present disclosure can be produced by powder metallurgy. FIG. 1 is a flow chart illustrating a method of producing a green compact in one embodiment of the present disclosure. Moreover, FIG. 2 is a flow chart illustrating a method of producing a fired product in one embodiment of the present disclosure. A method of producing a green compact in one embodiment of the present disclosure includes an alloy powder preparation step, a mixing step, and a compacting step. Moreover, a method of producing a fired product in one embodiment of the present disclosure further includes a firing step in addition to the steps of the aforementioned method of producing a green compact.

Furthermore, in methods of producing a green compact and a fired product in another embodiment of the present disclosure, a drying step of evaporating a solvent can be further included after the mixing step and before the compacting step. The following provides a specific description of each step. Note that matter that is not specifically mentioned can be performed in accordance with typical powder metallurgy techniques.

[Alloy powder preparation step]

First, an alloy powder is prepared as a raw material. The alloy powder is a noble metal alloy powder formed of an alloy of 5 or more noble metal elements and is required to satisfy the following conditions.

- Average particle diameter of 0.1 μm to 100 μm
- Crystallite size of 60 nm or more
- X-ray diffraction spectrum in which the number of peaks observed in a diffraction angle 2θ range of 38° to 44° is 1

• Average particle diameter: 0.1 μm to 100 μm

When the average particle diameter of the alloy powder is less than 0.1 μm, the apparent density noticeably decreases. A low powder apparent density is not suitable for producing a green compact and a fired product because this results in extremely large contraction (reduction of volume) during compacting and firing. Therefore, the average particle diameter is set as 0.1 μm or more. On the other hand, when the average particle diameter is larger than 100 μm, a fired product that is ultimately obtained becomes brittle. Therefore, the average particle diameter is set as 100 μm or less, preferably 80 μm or less, more preferably 50 μm or less, even more preferably 20 μm or less, and most preferably 10 μm or less.

• Crystallite size: 60 nm or more

In order that the crystallite size of a fired product that is ultimately obtained is 60 nm or more, it is necessary for the crystallite size of the alloy powder to be 60 nm or more. Therefore, the crystallite size of the alloy powder is set as 60 nm or more, and preferably 80 nm or more. On the other hand, the upper limit for the crystallite size is not specifically limited but may typically be 140 nm or less, or may be 120 nm or less.

The crystallite size can be determined from the full width at half maximum of a diffraction peak obtained through X-ray diffraction (XRD) measurement.

• Number of peaks in XRD spectrum: 1

In order that a fired product that is ultimately obtained exhibits an X-ray diffraction spectrum in which the number of peaks observed in a diffraction angle $2\theta$ range of 38° to 44° is 1, it is necessary for the number of peaks observed in a diffraction angle $2\theta$ range of 38° to 44° to also be 1 for the alloy powder.

• Coefficient of variation CV of content measured by EDX

The coefficient of variation CV of content measured by energy dispersive X-ray spectroscopy (EDX) is preferably 0.2 or less, and more preferably 0.15 or less for each of the constituent metal elements of the noble metal alloy powder. Note that when the coefficient of variation CV is said to be 0.2 or less, this means that the coefficient of variation CV of content of each of the constituent noble metal elements of the noble metal alloy powder is 0.2 or less. By using a powder having a coefficient of variation CV of 0.2 or less as the alloy powder, it is possible to also set the coefficient of variation CV as 0.2 or less in a noble metal alloy fired product that is ultimately obtained. On the other hand, no specific limitations are placed on the lower limit for the coefficient of variation CV because the lower the coefficient of variation CV is the better. Typically, the coefficient of variation CV may be 0.05 or more, or may be 0.08 or more.

No specific limitations are placed on the method by which the alloy powder is prepared. In one embodiment of the present disclosure, a noble metal alloy powder produced by a method described below can be used as the alloy powder. Note that the production method disclosed here can be broadly classified as two methods: a method in which firing is only performed once; and a method in which firing is performed a plurality of times. The former is a method that is suitable for producing a powder having a comparatively small average particle diameter, whereas the latter is a method that is suitable for producing a powder having a comparatively large average particle diameter. Each of these production methods is described below.

• Production of powder having comparatively small average particle diameter

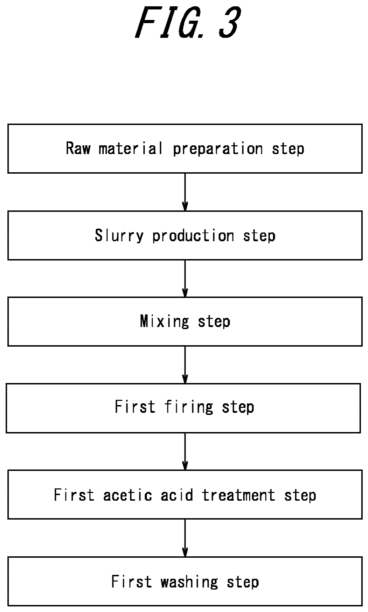

FIG. 3 is a flow chart illustrating a method of producing a noble metal alloy powder in one embodiment of the present disclosure. As illustrated in FIG. 3, the method of producing a noble metal alloy powder in one embodiment of the present disclosure includes the following steps (1) to (6).

(1) Raw material preparation step
(2) Slurry production step
(3) Mixing step
(4) First firing step
(5) First acetic acid treatment step
(6) First washing step

This production method is suitable for producing a powder having a comparatively small average particle diameter. Specifically, this production method is suitable for producing a powder having an average particle diameter of approximately 10 $\mu$m or less, is more suitable for producing a powder having an average particle diameter of 5 $\mu$m or less, and is even more suitable for producing a powder having an average particle diameter of 3 $\mu$m or less. The following provides a specific description of each step.

(1) Raw material preparation step

First, in the raw material preparation step, powders (raw material powders) that are to be used as raw materials for producing a noble metal alloy powder are prepared. A raw material powder is prepared separately for each of the constituent noble metal elements of the noble metal alloy that is to ultimately be produced. For example, in a case in which a five-component alloy is to be produced, 5 raw material powders should be prepared.

Although no specific limitations are placed on the particle diameter of the raw material powders, it is preferable to use fine raw material powders from a viewpoint of making the noble metal alloy powder that is ultimately obtained even more uniform. Specifically, the average particle diameter of each raw material powder that is used is preferably set as 1,000 nm or less, more preferably set as 500 nm or less, and even more preferably set as 100 nm or less. On the hand, the lower limit for the average particle diameter is not specifically limited and may be 1 nm or more, may be 5 nm or more, or may be 10 nm or more, for example.

Note that the average particle diameter of the raw material powder referred to here is defined as indicating the average particle diameter d that is determined from the specific surface area of the raw material powder using a perfect sphere model. The average particle diameter d ($\mu$m) is generally referred to as the BET diameter and, more specifically, can be calculated from the density $\rho$ (g/cm$^3$) of constituent particles of the raw material powder and the BET specific surface area s (m$^2$/g) by the following formula (1).

$$d = 6/\rho s \cdots (1)$$

Each raw material powder may be a metal powder or a metal oxide powder. For example, in the case of Pt, not only can Pt powder be used, but also platinum oxide ($PtO_2$) powder can be used. Likewise, oxide powders such as rhodium oxide ($RhO_2$, $RhO_3$) and palladium oxide (PdO) can freely be used. These oxide powders undergo thermal decomposition during firing to function as noble metal sources. Since there is fundamentally no change in terms of function as a raw material between a case in which a metal powder is used and a case in which a metal oxide powder is used, a metal powder or metal oxide powder should be selected according to ease of acquisition of the powder, etc.

However, in the case of Ru, it is preferable to use metal ruthenium powder as a raw material rather than ruthenium oxide ($RuO_2$) powder.

For example, in one embodiment of the present disclosure, it is preferable to use 5 or more types of powders selected from the group consisting of gold, silver, silver oxide, platinum, platinum oxide, palladium, palladium oxide, rhodium, ruthenium, rhodium oxide, iridium, iridium oxide, and osmium as raw material powders.

(2) Slurry production step

Next, the raw material powders, calcium carbonate, and water are mixed to obtain a slurry and the pH of the slurry is set as 8.0 or higher. The calcium carbonate thermally decomposes and at least some thereof is converted to calcium oxide in the firing step. Calcium carbonate and calcium oxide have an effect of impairing grain growth of a noble metal alloy, and thus contribute to micronization of the noble metal alloy powder that is ultimately obtained.

Although no specific limitations are placed on the additive amount of the calcium carbonate, the additive amount as a weight ratio relative to all raw material powders is preferably set as 0.1 times or more, more preferably set as 0.2 times or more, and even more preferably set as 0.5 times or more from a viewpoint of enhancing the above-described effect. On the other hand, although no specific limitations are placed on the upper limit for the additive amount, the effect reaches saturation when there is excessive addition. Consequently, the additive amount as a weight ratio relative to all raw material powders is preferably set as 10 times or less, more preferably set as 5 times or less, and even more preferably set as 2 times or less.

The calcium carbonate can be added in any form. Calcium carbonate powder is typically used. In a case in which calcium carbonate powder is used, the average particle diameter of the calcium carbonate powder is not specifically limited but is preferably set as 0.2 $\mu$m to 1.0 $\mu$m. Note that the average particle diameter of the calcium carbonate referred to here is defined as indicating the average particle diameter d that is determined from the specific surface area of the calcium carbonate using a perfect sphere model. The average particle diameter d ($\mu$m) is generally referred to as the BET diameter and, more specifically, can be calculated from the density $\rho$ (g/cm$^3$) of constituent particles of the calcium carbonate and the BET specific surface area s (m$^2$/g) by the following formula (1).

$$d = 6/\rho s \cdots (1)$$

pH: 8.0 or higher

It is important that the pH of the slurry is set as 8.0 or higher in the slurry production step. When the pH of the slurry is lower than 8.0, compositional uniformity decreases and the coefficient of variation CV in EDX measurement increases in the noble metal alloy powder that is ultimately obtained. Moreover, when the pH of the slurry is lower than 8.0, the number of peaks observed in a diffraction angle 2$\theta$ range of 38° to 44° in an XRD spectrum cannot be set as 1.

No specific limitations are placed on the method by which the pH of the slurry is adjusted. For example, in a situation in which the pH is lower than 8.0, the pH may be adjusted through addition of an alkali to the slurry. The pH can be adjusted by, for example, adding one or more selected from the group consisting of an alkali metal hydroxide, an alkaline earth metal hydroxide, and ammonia to the slurry. The alkali metal hydroxide may be sodium hydroxide or potassium hydroxide, for example. The alkaline earth metal hydroxide may be calcium hydroxide, for example. Note that the pH of the slurry may be measured using a typical pH meter.

No specific limitations are placed on the upper limit for the pH of the slurry. However, the effect of yielding a more uniform alloy reaches saturation when the pH is higher than 10. Moreover, adjustment of the pH to higher than 10 requires the addition of a large amount of an alkali. This may result in a large amount of sodium, potassium, or the like that has been added as the alkali remaining as an impurity. Moreover, in a situation in which ammonia is used as the alkali, this is hazardous because it causes the evolution of a large amount of harmful ammonia gas in the production process. Therefore, it is preferable that the pH of the slurry is set as 10 or lower.

(3) Mixing step

In the mixing step, the slurry is mixed. The mixing can be performed using any mixer without any specific limitations. The mixer may be a ball mill, a planetary mill (planetary ball mill), a bead mill, an attritor, or the like, for example. From a viewpoint of more uniform mixing, it is preferable to use a bead mill or a planetary mill, of which, a bead mill is preferable.

(4) First firing step

Next, the slurry that has been mixed in the mixing step is fired in a non-oxidizing atmosphere to obtain an alloy powder. By obtaining the alloy powder through firing in the present disclosure, it is possible to achieve a higher purity than in a case in which a wet reduction method is adopted. The firing can be performed by any device without any specific limitations. An electric furnace can typically be used.

The first firing step is performed in a non-oxidizing atmosphere in order to prevent oxidation of components. Any atmosphere that is non-oxidizing can be adopted as the non-oxidizing atmosphere without any specific limitations. Typically, a nitrogen gas atmosphere, an argon gas atmosphere, an atmosphere formed of hydrogen gas and nitrogen gas, an atmosphere formed of hydrogen gas and argon gas, or the like can be used. From a viewpoint of reliably preventing oxidation of raw material, it is preferable to use an atmosphere that is formed of hydrogen gas and nitrogen gas or that is formed of hydrogen gas and argon gas.

The firing temperature in the first firing step (first firing temperature) is not specifically limited and can be set as any temperature so long as it is a temperature at which the powders can be fired. The preferred first firing temperature is dependent on the melting point $T_M$ determined by the composition of the used noble metal alloy. From a viewpoint of promoting diffusion of the raw material powders and further increasing crystallinity, the first firing temperature $T_1$ is preferably set as not lower than $T_L$ defined by the following formula. On the other hand, although no specific limitations are placed on the upper limit for the first firing temperature, an excessively high first firing temperature may result in the occurrence of necking between alloy particles and the formation of coarse powder. Therefore, the first firing temperature $T_1$ is preferably set as not higher than $T_H$ defined by the following formula.

$$T_L \ (°C) = T_M \ (K) \times 0.55 - 273.15$$

$$T_H \ (°C) = T_M \ (K) \times 0.77 - 273.15$$

$T_M$ referred to here is taken to be a weighted average of the melting points of all of the constituent noble metal elements of the noble metal alloy. The contents (mass%) of the noble metal elements are used to calculate this weighted average.

The firing time in the first firing step is not specifically limited but is preferably set as 1 hour or more from a viewpoint of alloy grain growth. On the other hand, the firing time is preferably set as 5 hours or less from a viewpoint of production efficiency.

(5) First acetic acid treatment step

Next, a fired material that has been obtained through the first firing step is treated with acetic acid. The acetic acid treatment enables removal of calcium that is contained in the fired material. Note that in a situation in which an acid other than acetic acid (for example, hydrochloric acid or nitric acid) is used, not only calcium, but also noble metal elements dissolve, resulting in reduction of uniformity of the alloy. In contrast, dissolution of noble metal elements is not a concern with acetic acid irrespective of the concentration. Therefore, it is important that acetic acid is used for removal of calcium in the present disclosure.

Although no specific limitations are placed on the method of acetic acid treatment, the acetic acid treatment may typically be performed by stirring the fired material in an acetic acid aqueous solution to cause dissolution of calcium that is contained in the fired material. The acetic acid treatment can be performed any number of times so long as it is performed at least once. From a viewpoint of reducing the amount of calcium remaining as an impurity as much as possible, the acetic acid treatment is preferably performed at least twice, and is more preferably performed at least three times. In a case in which the acetic acid treatment is performed a plurality of times, a new acetic acid aqueous solution may be used each time the acetic acid treatment is performed.

In the acetic acid treatment, the fired material may be loaded into an acetic acid aqueous solution that has been prepared in advance, or the fired material may first be loaded into pure water, and then acetic acid may be added to the pure water.

The following describes a specific example of a suitable acetic acid treatment method.

First, the fired material is loaded into pure water and is stirred. This converts calcium oxide that is contained in the fired material to calcium hydroxide. Next, acetic acid is further added and stirred therewith to cause dissolution of the calcium hydroxide. Thereafter, stirring is stopped, settling is performed to cause sedimentation of powder, and then the supernatant is removed. The above corresponds to one repetition of acetic acid treatment. Thereafter, further addition and stirring of pure water and acetic acid, settling, and supernatant removal are repeated twice.

(6) First washing step

Next, the fired material (alloy powder) after the acetic acid treatment is water washed and dried (washing step). The water washing removes acid and also calcium that is in a dissolved state in the acid.

The water washing is preferably performed using pure water. No specific limitations are placed on the method by which the water washing is performed. For example, after removal of the supernatant in the acetic acid treatment, washing can be performed through addition and stirring of pure water. After the stirring has been stopped, settling is performed to cause sedimentation of powder, and then the supernatant is removed. The water washing is preferably repeated at least twice, and is more preferably repeated at least three times. After water washing, it is preferable that water and powder are separated by filtration and that the obtained powder is subjected to subsequent drying.

The drying can be performed by any method so long as it is a method by which water can be removed. Although natural drying may be used, heated drying is preferable in order to efficiently remove water. In the case of heated drying, the heating temperature is not specifically limited but is preferably set as 50°C or higher, and is more preferably set as 80°C or higher. The heating temperature may be 100°C or higher. On the other hand, although no specific limitations are placed on the upper limit for the heating temperature, an upper limit of 200°C or lower is typically preferable, and an upper limit of 150°C or lower is typically more preferable. The drying time is also not specifically limited and can be set as any time according to the amount of powder that is to be dried. From a viewpoint of sufficient drying, the drying time is preferably set as 1 hour or more, and is more preferably set as 5 hours or more. The drying time may be 10 hours or more. On the other hand, although no specific limitations are placed on the upper limit for the heating time, an upper limit of 100 hours or less is typically preferable, and an upper limit of 50 hours or less is typically more preferable.

Note that after drying, the resultant noble metal alloy powder is preferably further subjected to sieving. This makes it possible to break up particles that have aggregated in the process of washing.

Through the procedure set forth above, it is possible to obtain a noble metal alloy powder having a comparatively small particle diameter (for example, an average particle diameter of 10 $\mu$m or less).

• Production of powder having comparatively large average particle diameter

The following describes a method of producing a noble metal alloy powder in another embodiment of the present disclosure. The production method of the present embodiment is a method that is suitable for producing a comparatively large powder having an average particle diameter of up to 100 $\mu$m. Specifically, this production method is suitable for producing a powder having an average particle diameter of more than 5 $\mu$m, and is more suitable for producing a powder having an average particle diameter of more than 10 $\mu$m.

In the production method of the present embodiment, firing is performed a plurality of times. The production method of the present embodiment can be further broadly classified as two methods: a method in which firing is performed twice; and a method in which firing is performed three times. Each of these methods is described below.

(Case in which firing is performed twice)

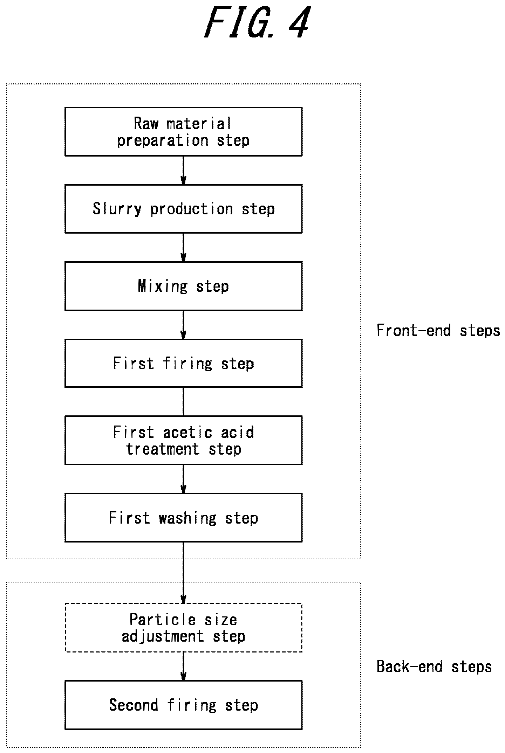

FIG. 4 is a flow chart illustrating the production method in a case in which firing is performed twice. As illustrated in FIG. 4, a method of producing a noble metal alloy powder in one embodiment of the present disclosure further includes a second firing step (7) in addition to steps (1) to (6) in the embodiment illustrated in FIG. 3.

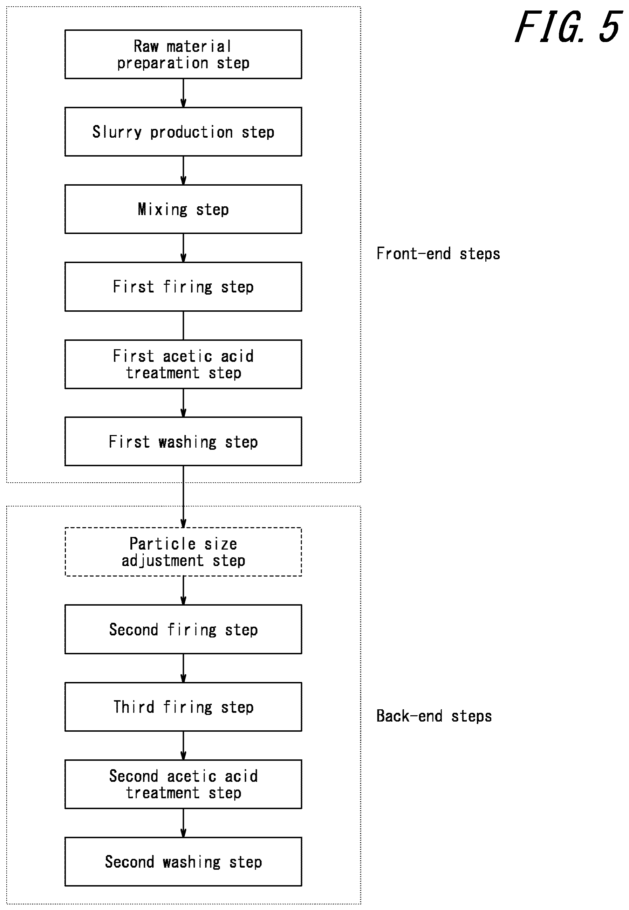

Note that for convenience of description, steps from the raw material preparation step to the first washing step are referred to as "front-end steps" and steps from the second firing step onwards are referred to as "back-end steps". Moreover, a particle size adjustment step may be further included after the first washing step and before the second firing step. In a case in which a particle size adjustment step is implemented, the particle size adjustment step is considered to be included among back-end steps as illustrated in FIG. 4 and FIG. 5.

In the present embodiment, a powder having high crystallinity and excellent compositional uniformity is first produced in the front-end steps. However, the powder that is obtained at this stage is composed of comparatively small particles (primary particles) having an average particle diameter of roughly 10 $\mu$m or less. Moreover, these primary particles aggregate with one another to form roughly spherical aggregates (secondary particles), and these secondary particles have a particle diameter of the order of tens of micrometers to a hundred micrometers. By further performing treatment of back-end steps with respect to this powder, it is possible to further increase the average particle diameter while maintaining high crystallinity and compositional uniformity.

• Particle size adjustment step

In the back-end steps, the particle size of the alloy powder after the first washing step may be adjusted (particle size adjustment step) prior to the subsequent second firing step. By performing particle size adjustment, a noble metal alloy powder having a desired particle size can be obtained more easily. The particle diameter of the noble metal alloy powder that is ultimately obtained is roughly equal to the particle diameter of the powder after particle size adjustment (i.e., the powder that is subjected to the subsequent second firing step). Accordingly, in the particle size adjustment step, the particle size should be adjusted in accordance with the desired particle diameter of the noble metal alloy powder that is to ultimately be obtained.

Although no specific limitations are placed on the method by which the particle size is adjusted, the particle size adjustment may typically be performed through sieving of the alloy powder. Any sieve can be used without any specific limitations. Note that powder that has passed through the sieve (passed material) or powder that has not passed through the sieve (retained material) can be used. Moreover, the particle size of the alloy powder may be adjusted by performing sieving twice or more. For example, the alloy powder may first be sieved so as to collect powder that has passed through the sieve. This removes coarse grains in the alloy powder. The collected powder may then be further sieved using a sieve having even finer openings so as to collect powder remaining on the sieve. This removes excessively fine powder. Through sieving using two sieves having different openings in this manner, it is possible to obtain a powder having the desired particle size.

Sieving of the alloy powder can also yield an effect of spheroidization of powder particles in addition to the effect of particle size adjustment. This is thought to be due to alloy powder in the form of aggregates being subjected to mechanical force such as vibration, rolling, and friction on the sieve, thereby reducing unevenness of particle surfaces. Although the effect of spheroidization described above is obtained both for passed material and retained material, the effect is more noticeable for retained material. Therefore, from a viewpoint of enhancing the spheroidization effect, it is preferable that at least once in the particle size adjustment step, the alloy powder is sieved and powder that has not passed through the sieve (retained material) is used.

• Second firing step

Next, the alloy powder is subjected to firing for a second time (second firing step). Note that in a case in which particle size adjustment is not performed, the alloy powder after the first washing step should be fired, whereas in a case in which particle size adjustment is performed, the alloy powder after particle size adjustment should be fired. Prior to the second firing, the secondary particles are brittle and are easily broken up by physical contact or shock. Accordingly, performing second firing causes necking between primary particles forming the secondary particles and fixes the state of the particles.

It should be noted that although calcium carbonate is used to impair necking between secondary particles in a subsequently described third firing step, mixing with calcium carbonate prior to the second firing breaks up aggregation of the secondary particles and makes it difficult to control the particle size because the secondary particles are brittle prior to the second firing as described above. Therefore, by stabilizing the structure of the secondary particles by performing second firing and subsequently mixing the secondary particles with calcium carbonate, it is possible to suitably control the particle size.

The temperature while the second firing is performed (second firing temperature) is not specifically limited and can be set as any temperature at which sintering between primary particles occurs. The preferred second firing temperature is dependent on the melting point $T_M$ determined by the composition of the used noble metal alloy. Therefore, the second firing temperature $T_2$ is preferably set as not lower than and not higher than $T_H$ defined by the following formulae.

$$T_L\ (°C) = T_M\ (K) \times 0.45 - 273.15$$

$$T_H\ (°C) = T_M\ (K) \times 0.60 - 273.15$$

$T_M$ referred to here is taken to be a weighted average of the melting points of all of the constituent noble metal elements of the noble metal alloy. The contents (mass%) of the noble metal elements are used to calculate this weighted average.

The time for which the second firing is performed (second firing time) is not specifically limited but is preferably set as 5 hours or less, and more preferably set as 2 hours or less. Moreover, the second firing time is preferably set as 30 minutes or more, more preferably set as 40 minutes or more, and even more preferably set as 50 minutes or more.

The second firing step is performed in a non-oxidizing atmosphere in order to prevent oxidation of components. Any atmosphere that is non-oxidizing can be adopted as the non-oxidizing atmosphere without any specific limitations. Typically, a nitrogen gas atmosphere, an argon gas atmosphere, an atmosphere formed of hydrogen gas and nitrogen gas, an atmosphere formed of hydrogen gas and argon gas, or the like can be used. From a viewpoint of reliably preventing oxidation of raw material, it is preferable to use an atmosphere that is formed of hydrogen gas and nitrogen gas or that is formed of hydrogen gas and argon gas.

(Case in which firing is performed three times)

FIG. 5 is a flow chart illustrating the production method for a case in which firing is performed three times. As illustrated in FIG. 5, a method of producing a noble metal alloy powder in one embodiment of the present disclosure further includes a third firing step (8), a second acetic acid treatment step (9), and a second washing step (10) in addition to steps (1) to (7) in the embodiment illustrated in FIG. 4. The following describes each of steps (8) to (10). Note that in the present embodiment, a particle size adjustment step can optionally be performed after the first washing step and before the second firing step in the same manner as in the case illustrated in FIG. 4.

• Third firing step

The alloy powder after the second firing is further fired in a non-oxidizing atmosphere (third firing step). By performing two stages of firing with respect to the alloy powder obtained through the front-end steps in this manner, it is possible to cause stronger bonding between the constituent primary particles of the secondary particles and to further increase the sphericity of particles. The third firing can be performed by any device without any specific limitations. An electric furnace can typically be used.

In the third firing step, firing is performed in a mixed state with calcium carbonate serving as a sintering inhibitor in order to prevent bonding of secondary particles to one another to form coarse particles. The additive amount and form of the calcium carbonate are not specifically limited and can be the same as in the previously described first firing step.

The third firing step is performed in a non-oxidizing atmosphere in order to prevent oxidation of components. Any atmosphere that is non-oxidizing can be adopted as the non-oxidizing atmosphere without any specific limitations. Typically, a nitrogen gas atmosphere, an argon gas atmosphere, an atmosphere formed of hydrogen gas and nitrogen gas, an atmosphere formed of hydrogen gas and argon gas, or the like can be used. From a viewpoint of reliably preventing oxidation of raw material, it is preferable to use an atmosphere that is formed of hydrogen gas and nitrogen gas or that is formed of hydrogen gas and argon gas.

The firing temperature in the third firing step (third firing temperature) is not specifically limited and can be set as any temperature so long as it is a temperature at which the powder can be fired. The preferred third firing temperature is dependent on the melting point $T_M$ determined by the composition of the used noble metal alloy. The third firing temperature $T_3$ is preferably set as not lower than defined by the following formula. On the other hand, although no specific limitations are placed on the upper limit for the third firing temperature, an excessively high third firing temperature may result in the occurrence of necking between alloy particles and the formation of coarse powder. Therefore, the third firing temperature $T_3$ is preferably set as not higher than $T_H$ defined by the following formula.

$$T_L\ (°C) = T_M\ (K) \times 0.55 - 273.15$$

$$T_H\ (°C) = T_M\ (K) \times 0.77 - 273.15$$

$T_M$ referred to here is taken to be a weighted average of the melting points of all of the constituent noble metal elements of the noble metal alloy. The contents (mass%) of the noble metal elements are used to calculate this weighted average.

The firing time in the third firing step is not specifically limited but is preferably set as 1 hour or more. On the other hand, the firing time is preferably set as 5 hours or less from a viewpoint of production efficiency.

• Second acetic acid treatment step

Next, the alloy powder (fired material) after the third firing step is treated with acetic acid (second acetic acid treatment step). The acetic acid treatment enables removal of calcium that is contained in the fired material. Note that in a situation in which an acid other than acetic acid (for example, hydrochloric acid or nitric acid) is used, not only calcium, but also noble metal elements dissolve, resulting in reduction of uniformity of the alloy. In contrast, dissolution of noble metal elements is not a concern with acetic acid irrespective of the concentration. Therefore, it is important that acetic acid is used for removal of calcium in the present disclosure.

The conditions of the second acetic acid treatment step are not specifically limited and can be the same as in the previously described first acetic acid treatment step.

• Second washing step

The alloy powder after the second acetic acid treatment is water washed and dried (second washing step). The water washing enables removal of acetic acid and also calcium that is in a dissolved state in the acetic acid. The conditions of the second washing step are not specifically limited and can be the same as in the previously described first washing step.

Through the treatment set forth above, it is possible to obtain a noble metal alloy powder satisfying the previously described conditions.

[Mixing step]

Next, the alloy powder serving as a raw material that has been prepared through the alloy powder preparation step is mixed with a resin (mixing step).

Any resin can be used as the resin without any specific limitations. For example, the resin may be one or more selected from the group consisting of commonly known polyamides such as nylon 11, nylon 12, and nylon 6, acrylonitrile-styrene (AS) resin, acrylonitrile-butadiene-styrene (ABS) resin, acrylonitrile-ethylene-styrene (AES) resin, vinyl acetate resin, polystyrene, polyethylene, polypropylene, polyvinyl chloride, acrylic resin, methacrylic resin, polyvinyl alcohol resin, polyvinyl ether, polyacetal, polycarbonate, polyethylene terephthalate, polybutylene terephthalate, polyvinyl butyral, polysulfone, polyetherimide, ethyl cellulose, cellulose acetate, fluororesin, polyolefin elastomer, and saturated polyester resin. A plurality of resins can be used together. Of these examples, it is preferable to use ethyl cellulose as the resin.

Moreover, in one embodiment of the present disclosure, a solvent is mixed with the alloy powder in addition to the resin in the mixing step. Although any solvent can be used as the solvent without any specific limitations, it is preferable to use a solvent having a boiling point of 300°C or lower. An organic solvent is typically used as the solvent. For example, an acetate, an ether, a hydrocarbon, or the like can be used as the solvent. More specifically, it is preferable to use one or more selected from dibutyl carbitol, butyl carbitol acetate, and texanol, and more preferable to use texanol.

The mixing can be performed by any method without any specific limitations. In a case in which a solvent is not used, the noble metal alloy powder and the resin can be mixed using any mixing means. Moreover, in a case in which a solvent is used, the noble metal alloy powder, the resin, and the solvent can be mixed using any mixing means. The mixing means may be a ball mill, a planetary mill (planetary ball mill), a bead mill, an attritor, a mortar, or the like, for example. From a viewpoint of more uniform mixing, it is preferable to use a bead mill or a planetary mill, of which, a bead mill is preferable.

In a case in which a solvent is used, it is preferable that kneading is performed after each component has been mixed from a viewpoint of uniformly dispersing the noble metal alloy powder in the solvent. The kneading can be performed by various types of devices such as a sand mill, a roll mill, a ball mill, a colloid mill, a jet mill, a bead mill, a kneader, a homogenizer, and a propeller-less mixer, for example. Of these devices, a roll mill is preferable. A two-roll mill, a three-roll mill, or the like can be used as the roll mill, for example, with the use of a three-roll mill being preferable.

[Drying step]

In a case in which a solvent has been used in the mixing step, it is preferable that the solvent is evaporated (drying step) after the mixing step and before a subsequent compacting step. Although no specific limitations are placed on the method by which drying is performed, the solvent may normally be evaporated through heating of a paste containing the solvent that has been obtained through the mixing step. In order to promote evaporation, the heating is preferably performed in a state in which the paste has been applied and spread onto the surface of a substrate such as a resin. For example, a PET (polyethylene terephthalate) film can be used as the substrate. The heating temperature should be adjusted according to the solvent that is used and can be set as approximately 120°C to 200°C, for example. Moreover, the heating can be performed by any method without any specific limitations. For example, the substrate onto which the paste has been applied may be heated on a hot plate or may be heated using a dryer.

Note that once the solvent has been removed by drying, the noble metal alloy powder and the resin may be in a hardened state. In such a situation, grinding may be performed to obtain a powdered form prior to the subsequent compacting step. The grinding can be performed by any method without any specific limitations. For example, the grinding may be performed using a ball mill, a planetary mill (planetary ball mill), a bead mill, an attritor, a mortar, or the like. In a case in which grinding is performed, excessively fine grinding is not necessary, and grinding should be performed to a size that can be accommodated in a mold used in the subsequent compacting step.

[Compacting step]

Next, a green compact (also referred to as a powder compact) is obtained by applying pressure to the alloy powder and the resin that have been mixed (compacting step). Although no specific limitations are placed on the method by which compacting is performed, the compacting may be performed by loading the powder into a mold and applying compacting pressure in the same manner as in normal powder metallurgy.

Although no specific limitations are placed on the method by which compacting pressure is applied, a pressing machine can typically be used. Any pressing machine can be used as the pressing machine without any specific limitations. For example, the pressing machine may be a twist pressing machine.

The compacting pressure is not specifically limited but is preferably set as 1,000 N or more, more preferably set as 1,500 N or more, and even more preferably set as 2,000 N or more from a viewpoint of ensuring strength of the green compact. The upper limit for the compacting pressure is not specifically limited and may be 1,000 N or less, or may be 5,000 N or less. Moreover, it is preferable that at least 30 seconds of holding is performed in a state in which the compacting pressure is applied, and more preferable that at least 60 seconds of holding is performed in a state in which the compacting pressure is applied.

Through the procedure set forth above, it is possible to produce a green compact in one embodiment of the present disclosure.

[Firing step]

In a case in which a fired product is to be produced, the green compact that has been obtained through the compacting step is further subjected to firing to obtain a fired product as illustrated in FIG. 2 (firing step). The firing causes decomposition and removal of the resin that was added as a binder and also causes particles of the noble metal alloy to bond to one another to form a fired product. The conditions during firing are not specifically limited and should be adjusted according to the noble metal alloy powder and the resin that are used.

For example, decomposition of the resin and bonding among the powder does not sufficiently progress when the firing temperature is too low. Therefore, the firing temperature is preferably set as 500°C or higher, more preferably set as 800°C or higher, and even more preferably set as 1000°C or higher. Note that in a situation in which high strength is required, for example, it is desirable that firing is performed at an even higher temperature to cause sufficient sintering among the powder. In such a situation, the firing temperature is preferably set as 1000°C or higher, more preferably set as 1200°C or higher, and even more preferably set as 1400°C or higher. A fired product obtained through firing at a high temperature in this manner is sometimes also referred to as a sintered product. On the other hand, the firing temperature is preferably set as 1800°C or lower, more preferably set as 1700°C or lower, and even more preferably set as 1600°C or lower since the effect reaches saturation when the firing temperature is excessively high. Note that firing at a lower temperature is adequate in a situation in which progression of sintering is not necessary. In such a situation, the firing temperature is preferably 1500°C or lower, more preferably 1400°C or lower, and even more preferably 1300°C or lower.

Heating to the firing temperature can be performed at any rate. For example, the time taken until the firing temperature is reached from the start of heating (heat-up time) may be 30 minutes to 240 minutes, or may be 60 minutes to 180 minutes.

Once the firing temperature has been reached, it is preferable that this temperature is held. The time for which the firing temperature is held is not specifically limited and may be 1 hour to 5 hours, or may be 2 hours to 4 hours, for example.

The firing step is preferably performed in a non-oxidizing atmosphere in order to prevent oxidation of components. Any atmosphere that is non-oxidizing can be adopted as the non-oxidizing atmosphere without any specific limitations. Typically, a nitrogen gas atmosphere, an argon gas atmosphere, an atmosphere formed of hydrogen gas and nitrogen gas, an atmosphere formed of hydrogen gas and argon gas, or the like can be used. From a viewpoint of reliably preventing oxidation of raw material, it is preferable to use an atmosphere that is formed of hydrogen gas and nitrogen gas or that is formed of hydrogen gas and argon gas.

The firing can be performed using any heating device. For example, an electric furnace can be used. It is preferable that an electric furnace that includes a means of controlling an atmosphere inside of the furnace is used as the electric furnace.

EXAMPLES

The following provides a more specific description of effects according to the present disclosure through examples and comparative examples of the present disclosure.

<Production of noble metal alloy powders>

First, five-component noble metal alloy powders formed of Ru, Rh, Pd, Ir, and Pt were produced by the following procedures for use in the examples.

(Powder no. 1)

First, powder no. 1 having a comparatively small average particle diameter was produced according to the procedure illustrated in FIG. 3. The specific conditions are described below.

[Front-end steps]

Powders of Pt, Pd, $IrO_2$, Ru, and Rh were prepared as raw material powders. Among these powders, Pt black, Pd black, and Rh black were respectively used as powders of Pt, Pd, and Rh. Moreover, the Ru powder was produced through reduction of $RuO_2$ powder.
The raw material powders were mixed with calcium carbonate powder and water (pure) to obtain a slurry. During mixing, an alkali for pH adjustment was added as necessary in order to set the pH of the slurry as 9.0.
Next, the slurry was mixed in a planetary ball mill. The mixing conditions were set as a rotation speed of 200 rpm and a mixing time of 6 hours. Moreover, a polyamide pot was used as a mixing vessel and polyamide balls of 10 mm in diameter were used as media.
The slurry after mixing was fired in an $N_2/H_2$ atmosphere to obtain an alloy powder. Specifically, the slurry was first dried at 130°C in a dryer to remove water and obtain a mixed powder. Next, the mixed powder was loaded into a crucible and was fired. The firing was performed using an atmosphere-type heating electric furnace. The atmosphere during firing was set as a 3% $H_2$/97% $N_2$ gas atmosphere, the firing temperature was set as 1300°C, and the firing time was set as 5 hours.
Next, the alloy powder that was obtained through the firing step was subjected to acetic acid treatment and was subsequently washed with pure water and dried.

(Acetic acid treatment)

The acetic acid treatment was performed three times by the following procedure. First, the fired material (alloy powder) was loaded into pure water and was stirred. This converted calcium oxide contained in the fired material to calcium hydroxide. Next, acetic acid was further added and stirred therewith to cause dissolution of the calcium hydroxide. Thereafter, stirring was stopped, settling was performed to cause sedimentation of powder, and then the supernatant was removed. The above corresponds to one repetition of acetic acid treatment. Thereafter, further addition and stirring of pure water and acetic acid, settling, and supernatant removal were repeated twice.
Next, washing with pure water was performed three times by the following procedure. First, once the supernatant had been removed in the third repetition of acetic acid treatment, pure water was added and stirred. After the stirring had been stopped, settling was performed to cause sedimentation of powder, and then the supernatant was removed. Three repetitions of the washing described above were performed.

(Drying)

After the washing, water and powder were separated by filtration, and the obtained powder was dried. The drying was performed at 130°C for 12 hours.
The powder after drying was sieved to cause disintegration of aggregated powder. A test sieve made of stainless steel that had an opening size of 125 $\mu$m was used as the sieve. Note that all particles passed through the sieve without remaining on the sieve.

(Powder no. 2)

Next, powder no. 2 having a comparatively large average particle diameter was produced according to the procedure illustrated in FIG. 5. Specifically, powder no. 1 described above was further subjected to back-end steps under the following conditions.

(Particle size adjustment step)

The alloy powder obtained through the front-end steps was subjected to particle size adjustment. Specifically, the alloy powder was sieved using a sieve having an opening size of 53 μm, and powder that passed through the sieve was further sieved using a sieve having an opening size of 38 μm. Test sieves made of stainless steel were used as the sieves.

(Second firing step)

Next, the alloy powder after the particle size adjustment step was subjected to second firing in a non-oxidizing atmosphere. The second firing was performed using an atmosphere-type heating electric furnace with the alloy powder loaded into a crucible. The atmosphere during firing was set as a 100% $N_2$ gas atmosphere, the second firing temperature was set as 1000°C, and the second firing time was set as 1 hour.

(Third firing step)

Next, the powder after the second firing step was subjected to third firing in a state in which the powder was further mixed with calcium carbonate. Specifically, the powder after the second firing step was first mixed with calcium carbonate powder to obtain a mixed powder. The additive amount of calcium carbonate during this mixing was set as a volume ratio of 5 times relative to the powder. The mixing was performed for 1 minute in a powder mixer. Next, the mixed powder was loaded into a crucible and was fired in a non-oxidizing atmosphere. The firing was performed using an atmosphere-type heating electric furnace. The atmosphere during firing was set as a 100% $N_2$ gas atmosphere, the third firing temperature was set as 1300°C, and the third firing time was set as 5 hours.

(Second acetic acid treatment step)

Next, the alloy powder that was obtained through the firing step was subjected to second acetic acid treatment. The second acetic acid treatment was performed three times by the following procedure in the same way as in the first acetic acid treatment step. First, the fired material (alloy powder) was loaded into pure water and was stirred. This converted calcium oxide contained in the fired material to calcium hydroxide. Next, acetic acid was further added and stirred therewith to cause dissolution of the calcium hydroxide. Thereafter, stirring was stopped, settling was performed to cause sedimentation of powder, and then the supernatant was removed. The above corresponds to one repetition of acetic acid treatment. Thereafter, further addition and stirring of pure water and acetic acid, settling, and supernatant removal were repeated twice.

(Second washing step)

Next, washing with pure water in the same way as in the first washing step was performed three times by the following procedure. First, once the supernatant had been removed in the third repetition of acetic acid treatment, pure water was added and stirred. After the stirring had been stopped, settling was performed to cause sedimentation of powder, and then the supernatant was removed. Three repetitions of the washing described above were performed. After the washing, water and powder were separated by filtration, and the obtained powder was dried. The drying was performed at 130°C for 12 hours.

Next, the average particle diameter, the crystallite size, and the number of peaks in an XRD spectrum were measured by the following procedures for each of the obtained noble metal alloy powders. The measurement results are shown in Table 1.

(Average particle diameter)

The average particle diameter of each of the obtained noble metal alloy powders was measured using a laser diffraction particle size analyzer MT-3000 produced by MicrotracBEL Corp. Specifically, the alloy powder was added to a sodium hexametaphosphate aqueous solution that circulated inside of the particle size analyzer, was dispersed for 1 minute by ultrasonication, and then a particle size distribution was measured. The determined 50% particle diameter (D50) by volume was taken to be the average particle diameter of the noble metal alloy powder.

(Crystallite size)

The crystallite size of each of the obtained noble metal alloy powders was measured by an X-ray diffractometer Ultima IV produced by Rigaku Corporation. In this measurement, the powder serving as a measurement subject was loaded into a glass cell for powder measurement to obtain a sample. The measurement conditions were set as a Cu target, a tube voltage of 40 kV, a tube current of 40 mA, a scan range of 10° to 100°, a sampling interval of 0.02°, and a scan speed of 30°/min. The crystallite size was calculated by the Scherrer equation from the full width at half maximum of a diffraction peak obtained through the measurement.

(Number of peaks in XRD spectrum)

With respect to the XRD spectrum obtained in measurement of crystallite size described above, the number of peaks observed in a diffraction angle 2θ range of 38° to 44° was determined. Note that in counting of the number of peaks, peak separation of XRD peaks was performed by Gaussian fitting, and peaks having a peak width of at least 0.1° and also having a peak intensity of at least 1/100th of that of the maximum peak were regarded as peaks.

[Table 1]

| Powder no. | Noble metal alloy powder | | | | | | | |
|---|---|---|---|---|---|---|---|---|
| | Measurement results | | | | | | | |
| | Average particle diameter ($\mu$m) | Crystallite size (nm) | XRD number of peaks | EDX coefficient of variation | | | | |
| | | | | Ru | Rh | Pd | Ir | Pt |
| 1 | 1 | 76.47 | 1 | 0.103 | 0.143 | 0.138 | 0.120 | 0.141 |
| 2 | 40 | 61.86 | 1 | 0.103 | 0.080 | 0.095 | 0.150 | 0.096 |

<Production of green compact>

Next, each of the obtained noble metal alloy powders was used to produce a green compact by the procedure illustrated in FIG. 1.

Specifically, the noble metal alloy powder, a resin, and a solvent were first each weighed out such that the contents thereof in a final paste would be 80 mass% of the noble metal alloy powder, 1.8 mass% of the resin, and 18.2 mass% of the solvent and were then mixed into the form of a paste. Ethyl cellulose and texanol were used respectively as the resin and the solvent.

Next, the obtained paste was kneaded using a three-roll mill to cause sufficient dispersion of each component (mixing step).

Next, the paste was applied as a film onto an alumina substrate by screen printing. Next, drying was performed at 120°C to volatilize the solvent contained in the applied paste and form a thin film (drying step). The obtained thin film was peeled from the substrate and was ground in a crucible to obtain an alloy powder-resin mixed powder in which the noble metal alloy powder and the resin were in a sufficiently uniformly mixed state.

Next, a green compact (powder compact) was produced by applying pressure to the alloy powder-resin mixed powder (compacting step). Specifically, the alloy powder-resin mixed powder was loaded into a mold and pressure was applied using a pressing machine. The compacting pressure was set as 500 MPa and the pressing time was set as 1 minute.

<Production of fired product>

The green compact that had been obtained in the compacting step was fired to obtain a fired product. The firing temperature was set as indicated in Table 2. The atmosphere during firing was set as a 3% $H_2$/97% $N_2$ gas atmosphere, and the firing time was set as 5 hours.

Note that for the purpose of comparison, a green compact and a fired product were also produced using a mixed powder instead of the alloy powder. The mixed powder was obtained by mixing Ru powder, Rh powder, Pd powder, Ir powder, and Pt powder such that each noble metal element was an equiatomic quantity. Other conditions were the same as those in the above-described examples.

The crystallite size, the number of peaks in an XRD spectrum, and the coefficient of variation CV in EDX were measured by the following procedures with respect to each of the obtained green compacts and fired products (hereinafter, referred to as samples). The measurement results are shown in Table 2.

(Average particle diameter)

The average particle diameter of the alloy powder contained in each green compact among the obtained samples was measured using a laser diffraction particle size analyzer MT-3000 produced by MicrotracBEL Corp. Specifically, the alloy powder was added to a sodium hexametaphosphate aqueous solution that circulated inside of the particle size analyzer, was dispersed for 1 minute by ultrasonication, and then a particle size distribution was measured. The determined 50% particle diameter (D50) by volume was taken to be the average particle diameter of the noble metal alloy powder. Note that the average particle diameter in the green compact was the same as the average particle diameter of the noble metal alloy powder used as a raw material. The average particle diameter was not measured for fired products. This is because particles have been sintered with one another and do not maintain a particulate form in the fired products.

(Number of peaks in XRD spectrum)

An XRD spectrum of each of the obtained samples was measured by an X-ray diffractometer Ultima IV produced by Rigaku Corporation. The measurement conditions were set as a Cu target, a tube voltage of 40 kV, a tube current of 40 mA, a scan range of 10° to 100°, a sampling interval of 0.02°, and a scan speed of 30°/min. In the obtained XRD spectrum, the number of peaks observed in a diffraction angle $2\theta$ range of 38° to 44° was determined. Note that in counting of the number of peaks, peak separation of XRD peaks was performed by Gaussian fitting, and peaks having a peak width of at least 0.1° and also having a peak intensity of at least 1/100th of that of the maximum peak were regarded as peaks.

(Crystallite size)

The crystallite size of each of the obtained noble metal alloy powders was measured by an X-ray diffractometer Ultima IV produced by Rigaku Corporation. In this measurement, the powder serving as a measurement subject was loaded into a glass cell for powder measurement to obtain a sample. The measurement conditions were set as a Cu target, a tube voltage of 40 kV, a tube current of 40 mA, a scan range of 10° to 100°, a sampling interval of 0.02°, and a scan speed of 30°/min. The crystallite size was calculated by the Scherrer equation from the full width at half maximum of a diffraction peak obtained through the measurement.
However, in the case of comparative example samples that were produced using the mixed powder, a plurality of peaks were observed in the XRD spectrum used for calculation of crystallite size. Therefore, the crystallite size cannot be unambiguously determined and is not shown in Table 2.

(Coefficient of variation CV in EDX)

The coefficient of variation CV of content of each noble metal element contained in each of the obtained samples was calculated from measurement results of energy dispersive X-ray spectroscopy. A scanning electron microscope (SEM)-energy dispersive X-ray analyzer (EDX) JSM-6010LA produced by JEOL Ltd. was used in this measurement. The measurement was performed with an alumina substrate and a film formed on the substrate fixed on a sample stage by carbon tape. The measurement conditions were set as a magnification of ×3,000 and an accelerating voltage of 20 kV. EDX quantitative measurement was performed at 30 randomly selected points under these conditions to determine the content of each noble metal element. The coefficient of variation CV was calculated from the average and standard deviation of the determined contents.

[Table 2]

| No. | Green compact and fired product | | | | | | | | | | | Note |
| | Used powder | Type | Firing temperature (°C) | Measurement results | | | | | | | | |
| | | | | Average particle diameter ($\mu$m) | Crystallite size (nm) | XRD number of peaks | EDX coefficient of variation | | | | | |
| | | | | | | | Ru | Rh | Pd | Ir | Pt | |
|---|---|---|---|---|---|---|---|---|---|---|---|---|
| 1 | Powder no. 1 | Shaped product | - | 1 | 76.47 | 1 | 0.103 | 0.143 | 0.138 | 0.120 | 0.141 | Example |
| 2 | Powder no. 1 | Fired product | 1000 | - | 67.10 | 1 | 0.069 | 0.071 | 0.094 | 0.108 | 0.090 | Example |
| 3 | Powder no. 1 | Fired product | 1300 | - | 123.29 | 1 | 0.033 | 0.026 | 0.034 | 0.034 | 0.023 | Example |
| 4 | Powder no. 2 | Shaped product | - | 40 | 61.86 | 1 | 0.103 | 0.080 | 0.095 | 0.150 | 0.096 | Example |
| 5 | Powder no. 2 | Fired product | 1000 | - | 63.01 | 1 | 0.156 | 0.109 | 0.106 | 0.154 | 0.095 | Example |
| 6 | Powder no. 2 | Fired product | 1300 | - | 115.44 | 1 | 0.056 | 0.065 | 0.067 | 0.039 | 0.059 | Example |
| 7 | Mixed powder | Shaped product | - | - | - | 7 | 0.224 | 0.192 | 0.301 | 0.772 | 0.222 | Comparative example |
| 8 | Mixed powder | Fired product | 1000 | - | - | 6 | 1.249 | 0.399 | 0.240 | 1.234 | 0.213 | Comparative example |
| 9 | Mixed powder | Fired product | 1300 | - | - | 7 | 1.692 | 0.549 | 0.211 | 0.956 | 0.308 | Comparative example |

It can be seen from the results illustrated in Table 2 that for green compacts and fired products according to the present disclosure, the number of peaks in an XRD spectrum was 1 and the coefficient of variation CV in EDX was 0.2 or less for all of the 5 noble metal elements. This demonstrates that the noble metal alloy elements are completely alloyed and that compositional uniformity is extremely high. In contrast, it can be seen that alloying did not sufficiently progress and that there is a non-uniform composition in the comparative examples where the mixed powder was used.

**Claims**

1. A green compact comprising an alloy powder and a resin, wherein the alloy powder:

   is a noble metal alloy powder formed of an alloy of 5 or more noble metal elements;
   has an average particle diameter of 0.1 $\mu$m to 100 $\mu$m;
   has a crystallite size of 60 nm or more; and
   exhibits an X-ray diffraction spectrum in which a number of peaks observed in a diffraction angle $2\theta$ range of 38° to 44° is 1.

2. The green compact according to claim 1, wherein the noble metal alloy powder has a coefficient of variation CV of content measured by energy dispersive X-ray spectroscopy of 0.2 or less for each of the noble metal elements.

3. A fired product of a noble metal alloy, wherein

   the noble metal alloy is a noble metal alloy formed of 5 or more noble metal elements, and
   the fired product:

      has a crystallite size of 60 nm or more; and
      exhibits an X-ray diffraction spectrum in which a number of peaks observed in a diffraction angle $2\theta$ range of 38° to 44° is 1.

4. The fired product according to claim 3, wherein a coefficient of variation CV of content measured by energy dispersive X-ray spectroscopy is 0.2 or less for each of the noble metal elements.

5. A method of producing a green compact formed of an alloy powder and a resin, comprising:

   an alloy powder preparation step of preparing the alloy powder as a raw material;
   a mixing step of mixing the resin with the alloy powder; and
   a compacting step of applying pressure to the alloy powder and the resin that have been mixed in the mixing step to obtain a green compact,
   wherein
   the alloy powder:

      is a noble metal alloy powder formed of an alloy of 5 or more noble metal elements;
      has an average particle diameter of 0.1 $\mu$m to 100 $\mu$m;
      has a crystallite size of 60 nm or more; and
      exhibits an X-ray diffraction spectrum in which a number of peaks observed in a diffraction angle $2\theta$ range of 38° to 44° is 1.

6. The method of producing a green compact according to claim 5, wherein

   a solvent is mixed with the alloy powder in addition to the resin in the mixing step, and
   the method further comprises a drying step of evaporating the solvent after the mixing step and before the compacting step.

7. A method of producing a fired product of a noble metal alloy, comprising:

   an alloy powder preparation step of preparing an alloy powder as a raw material;
   a mixing step of mixing a resin with the alloy powder;
   a compacting step of applying pressure to the alloy powder and the resin that have been mixed in the mixing step to obtain a green compact; and
a firing step of firing the green compact to obtain a fired product,
wherein
the alloy powder:

is a noble metal alloy powder formed of an alloy of 5 or more noble metal elements;
has an average particle diameter of 0.1 $\mu$m to 100 $\mu$m;
has a crystallite size of 60 nm or more; and
exhibits an X-ray diffraction spectrum in which a number of peaks observed in a diffraction angle $2\theta$ range of 38° to 44° is 1.

8. The method of producing a fired product according to claim 7, wherein

a solvent is mixed with the alloy powder in addition to the resin in the mixing step, and
the method further comprises a drying step of evaporating the solvent after the mixing step and before the compacting step.

# FIG. 1

| Alloy powder preparation step |
| :---: |

↓

| Mixing step |
| :---: |

↓

| Drying step |
| :---: |

↓

| Compacting step |
| :---: |

# FIG. 2

```
┌─────────────────────────────────────┐
│    Alloy powder preparation step     │
└─────────────────────────────────────┘
                  │
                  ▼
┌─────────────────────────────────────┐
│             Mixing step              │
└─────────────────────────────────────┘
                  │
                  ▼
┌ ─ ─ ─ ─ ─ ─ ─ ─ ─ ─ ─ ─ ─ ─ ─ ─ ─ ─ ┐
│             Drying step              │
└ ─ ─ ─ ─ ─ ─ ─ ─ ─ ─ ─ ─ ─ ─ ─ ─ ─ ─ ┘
                  │
                  ▼
┌─────────────────────────────────────┐
│           Compacting step            │
└─────────────────────────────────────┘
                  │
                  ▼
┌─────────────────────────────────────┐
│             Firing step              │
└─────────────────────────────────────┘
```

# FIG. 3

```
┌─────────────────────────────────────┐
│     Raw material preparation step    │
└─────────────────────────────────────┘
                   │
                   ▼
┌─────────────────────────────────────┐
│        Slurry production step        │
└─────────────────────────────────────┘
                   │
                   ▼
┌─────────────────────────────────────┐
│             Mixing step              │
└─────────────────────────────────────┘
                   │
                   ▼
┌─────────────────────────────────────┐
│           First firing step          │
└─────────────────────────────────────┘
                   │
                   ▼
┌─────────────────────────────────────┐
│     First acetic acid treatment step │
└─────────────────────────────────────┘
                   │
                   ▼
┌─────────────────────────────────────┐
│          First washing step          │
└─────────────────────────────────────┘
```

# FIG. 4

```
┌─────────────────────────────────────────────┐
│  ┌─────────────────────────────┐             │
│  │      Raw material           │             │
│  │    preparation step         │             │
│  └─────────────────────────────┘             │
│                 │                            │
│                 ▼                            │
│  ┌─────────────────────────────┐             │
│  │    Slurry production step    │            │
│  └─────────────────────────────┘             │
│                 │                            │
│                 ▼                            │
│  ┌─────────────────────────────┐             │
│  │        Mixing step          │             │   Front-end steps
│  └─────────────────────────────┘             │
│                 │                            │
│                 ▼                            │
│  ┌─────────────────────────────┐             │
│  │     First firing step        │            │
│  └─────────────────────────────┘             │
│                 │                            │
│                 ▼                            │
│  ┌─────────────────────────────┐             │
│  │     First acetic acid       │             │
│  │      treatment step          │            │
│  └─────────────────────────────┘             │
│                 │                            │
│                 ▼                            │
│  ┌─────────────────────────────┐             │
│  │     First washing step       │            │
│  └─────────────────────────────┘             │
└─────────────────────────────────────────────┘
                  │
┌─────────────────┼───────────────────────────┐
│                 ▼                            │
│  ┌ ─ ─ ─ ─ ─ ─ ─ ─ ─ ─ ─ ─ ─ ─ ┐             │
│       Particle size                         │
│  │  adjustment step            │             │
│  └ ─ ─ ─ ─ ─ ─ ─ ─ ─ ─ ─ ─ ─ ─ ┘             │   Back-end steps
│                 │                            │
│                 ▼                            │
│  ┌─────────────────────────────┐             │
│  │     Second firing step       │            │
│  └─────────────────────────────┘             │
└─────────────────────────────────────────────┘
```

FIG. 5

Front-end steps

```
┌─────────────────────┐
│    Raw material      │
│  preparation step    │
└─────────────────────┘
          │
          ▼
┌─────────────────────┐
│ Slurry production step │
└─────────────────────┘
          │
          ▼
┌─────────────────────┐
│     Mixing step      │
└─────────────────────┘
          │
          ▼
┌─────────────────────┐
│  First firing step   │
└─────────────────────┘
          │
          ▼
┌─────────────────────┐
│   First acetic acid  │
│    treatment step    │
└─────────────────────┘
          │
          ▼
┌─────────────────────┐
│  First washing step  │
└─────────────────────┘
```

Back-end steps

```
┌─────────────────────┐
│    Particle size     │
│   adjustment step    │
└─────────────────────┘
          │
          ▼
┌─────────────────────┐
│  Second firing step  │
└─────────────────────┘
          │
          ▼
┌─────────────────────┐
│   Third firing step  │
└─────────────────────┘
          │
          ▼
┌─────────────────────┐
│  Second acetic acid  │
│    treatment step    │
└─────────────────────┘
          │
          ▼
┌─────────────────────┐
│ Second washing step  │
└─────────────────────┘
```

## INTERNATIONAL SEARCH REPORT

| International application No. |
|---|
| **PCT/JP2024/006397** |

| | |
|---|---|
| **A.** | **CLASSIFICATION OF SUBJECT MATTER** |

*B22F 1/00*(2022.01)i; *B22F 1/05*(2022.01)i; *B22F 1/07*(2022.01)i; *B22F 1/14*(2022.01)i; *B22F 9/20*(2006.01)i;
*B82Y 30/00*(2011.01)i; *C22C 5/00*(2006.01)i; *C22C 30/00*(2006.01)i
FI:  B22F1/00 K; C22C5/00; B22F1/05; B22F1/07; B82Y30/00; B22F9/20 Z; C22C30/00; B22F1/14 400

According to International Patent Classification (IPC) or to both national classification and IPC

| | |
|---|---|
| **B.** | **FIELDS SEARCHED** |

Minimum documentation searched (classification system followed by classification symbols)

B22F1/00; B22F1/05; B22F1/07; B22F1/14; B22F9/20; B82Y30/00; C22C5/00; C22C30/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| A | WO 2021/020377 A1 (KYOTO UNIVERSITY) 04 February 2021 (2021-02-04)<br>entire text, all drawings | 1-8 |
| A | WO 2018/154292 A1 (SWANSEA UNIVERSITY) 30 August 2018 (2018-08-30)<br>entire text, all drawings | 1-8 |
| A | WO 2022/132883 A1 (UNIVERSITY OF MARYLAND, COLLEGE PARK) 23 June 2022 (2022-06-23)<br>entire text, all drawings | 1-8 |
| A | JP 8-325602 A (TANAKA KIKINZOKU INTERNATL KK) 10 December 1996 (1996-12-10)<br>entire text, all drawings | 1-8 |
| A | JP 10-102106 A (TANAKA KIKINZOKU KOGYO KK) 21 April 1998 (1998-04-21)<br>entire text, all drawings | 1-8 |

☐ Further documents are listed in the continuation of Box C.　　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **24 April 2024** | **14 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

| Patent document cited in search report | | | Publication date (day/month/year) | Patent family member(s) | | | Publication date (day/month/year) |
|---|---|---|---|---|---|---|---|
| WO | 2021/020377 | A1 | 04 February 2021 | US | 2022/0258231 | A1 | |
| | | | | EP | 4005701 | A1 | |
| | | | | TW | 202108240 | A | |
| WO | 2018/154292 | A1 | 30 August 2018 | (Family: none) | | | |
| WO | 2022/132883 | A1 | 23 June 2022 | EP | 4263090 | A1 | |
| | | | | KR | 10-2023-0118986 | A | |
| JP | 8-325602 | A | 10 December 1996 | (Family: none) | | | |
| JP | 10-102106 | A | 21 April 1998 | (Family: none) | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H06057303 A


**Non-patent literature cited in the description**

- *Journal of the American Chemical Society*, February 2022, vol. 144 (8), 3365-3369